Europäisches Patentamt

European Patent Office

Office européen des brevets

(11) Numéro de publication: **0 296 511 B1**

## (12) FASCICULE DE BREVET EUROPEEN

(45) Date de publication de fascicule du brevet: **26.08.92**   (51) Int. Cl.⁵: **H01L 21/48,** H01L 23/50

(21) Numéro de dépôt: **88109743.0**

(22) Date de dépôt: **18.06.88**

### (54) Procédé de fabrication d'un ruban destiné à fournir des circuits pour modules électroniques, et ruban obtenu selon ce procédé.

(30) Priorité: **22.06.87 FR 8708790**

(43) Date de publication de la demande:
**28.12.88 Bulletin  88/52**

(45) Mention de la délivrance du brevet:
**26.08.92 Bulletin  92/35**

(84) Etats contractants désignés:
**AT CH FR IT LI NL SE**

(56) Documents cités:
**EP-A- 0 201 952**
**CH-A- 608 314**
**DE-B- 1 156 131**
**GB-A- 2 031 796**

(73) Titulaire: **ETA SA Fabriques d'Ebauches**
**Schild-Rust-Strasse 17**
**CH-2540 Granges(CH)**

(72) Inventeur: **Stampfli, Jean-Marcel**
**Chantemerle 3**
**CH-2525 Le Landeron(CH)**

(74) Mandataire: **de Montmollin, Henri et al**
**ICB Ingénieurs Conseils en Brevets SA Passage Max Meuron 6**
**CH-2001 Neuchâtel(CH)**

1                    EP 0 296 511 B1                    2

## Description

La présente invention, qui a trait aux modules électroniques souples et de faible épaisseur, concerne un procédé de fabrication en continu des circuits pour de tels modules, chaque circuit comprenant un substrat isolant et un réseau de conducteurs minces, les conducteurs étant disposés sur une face du substrat. Au moins un composant électronique est en outre placé sur une face du circuit et connecté aux conducteurs, le composant et le circuit formant le module. L'invention concerne plus particulièrement un procédé de fabrication en continu d'un ruban, produit intermédiaire, destiné à fournir une multitude de circuits pour modules, ainsi que le ruban obtenu selon ce procédé.

De tels modules sont bien connus et, étant donné leur épaisseur réduite et leur souplesse, ils sont principalement destinés à équiper des produits présentant un faible encombrement. Parmi ces produits il y a lieu de citer, en particulier, les cartes électroniques, appelées aussi "smart cards", telles que les cartes de crédit, les cartes de parking, les cartes pour les appels téléphoniques etc, ou bien encore les mouvements de montres électroniques.

Un procédé de fabrication en continu de modules pour pièces d'horlogerie électroniques, comportant un circuit mince et des composants électroniques, est, par exemple, décrit en détail dans le brevet FR 2 412 225. Ce procédé consiste essentiellement à se munir d'un film isolant en forme de ruban servant de substrat, à coller sur ce film une bande métallique mince, à former les réseaux de conducteurs par voie photolithographique en éliminant la partie inutile de la bande, le substrat et les conducteurs déterminant les circuits, à connecter à ces conducteurs les composants électroniques, enfin à séparer par étampage les modules ainsi obtenus du film leur servant de support.

Cette manière de faire présente cependant plusieurs inconvénients. En effet, d'une part, l'usinage de la bande métallique par photolithographie, outre qu'il est long et coûteux, comporte une étape d'attaque chimique du métal par un solvant qui, en provoquant une pollution ionique du film isolant, diminue la fiabilité à long terme des modules. D'autre part, étant donné que l'usinage photolithographique forme des conducteurs électriquement isolés, les modules, s'ils comportent un composant électronique sensible aux décharges électrostatiques, par exemple un circuit intégré, seront aussi très sensibles à de telles décharges dans la phase finale de leur fabrication, ou en stockage.

Un autre procédé de fabrication en continu de circuits pour modules, présentant l'avantage de ne pas nécessiter d'attaque chimique, est décrit dans le brevet CH 608 314. Il consiste à se munir d'un film isolant, également en forme de ruban, et à coller sur ce film une bande métallique dans laquelle les conducteurs ont été préalablement découpés par étampage, chaque conducteur restant lié au reste de la bande par une de ses extrémités. Toutefois, simultanément à l'opération de collage, les conducteurs sont en outre coupés de la bande. Ainsi ce procédé, comme le précédent, fournit des circuits avec des conducteurs isolés, et donc des modules non protégés contre les chocs électriques.

Les procédés connus de l'art antérieur présentent donc l'inconvénient de comporter une phase consistant à enlever de la bande métallique tout le métal en excès, pour ne laisser sur le substrat des circuits que des conducteurs ayant leur forme définitive, et donc électriquement isolés.

Un but de l'invention est de proposer un procédé de fabrication en continu d'un ruban destiné à fournir des circuits pour modules ne présentant pas cet inconvénient.

Pour atteindre cet objectif, le procédé de fabrication selon l'invention est particulièrement remarquable en ce qu'il consiste :
- à se munir d'une bande métallique comportant une série d'ouvertures traversant la bande de part en part, ces ouvertures délimitant les réseaux de conducteurs des circuits de manière que chaque conducteur reste lié à la bande par un pont ;
- à se munir d'une pluralité de feuilles isolantes, ces feuilles étant destinées à former lesdits substrats des circuits ; et
- à coller chaque feuille à la suite l'une de l'autre sur une face de la bande au moyen d'un matériau adhésif de manière que chaque réseau de conducteurs forme, avec au moins une partie d'une feuille, un circuit, la bande et les feuilles formant, de leur coté, le ruban.

Un avantage du procédé selon l'invention est de fournir un ruban qui comporte, sur une face, des conducteurs restant liés galvaniquement avec la bande métallique.

Un autre objet de l'invention est le ruban obtenu selon le présent procédé.

D'autres caractéristiques et avantages de la présente invention ressortiront de la description qui va suivre, faite en regard du dessin annexé et donnant, à titre explicatif mais nullement limitatif, un exemple du procédé de fabrication en continu d'un tel ruban destiné à fournir des circuits pour modules électroniques. Sur ce dessin, où les mêmes références se rapportent à des éléments analogues:
- la figure 1 représente une partie d'une bande métallique mince pourvue d'une série d'ouvertures délimitant les conducteurs des circuits de modules électroniques destinés à

2

équiper des cartes de crédit;
- la figure 2 montre une feuille isolante comportant des trous pour les connexions de quatre circuits intégrés pour cartes de crédit;
- la figure 3 est une vue montrant la feuille isolante collée sur la bande métallique, l'ensemble formant une partie du ruban selon l'invention, cette partie comportant quatre circuits ;
- la figure 4 montre les circuits représentés sur la figure 3 sur lesquels sont disposés quatre circuits intégrés pour constituer quatre modules électroniques;
- la figure 5 représente les modules électroniques dans leur forme finale avec les circuits intégrés protégés par une résine, chaque module étant prédécoupé mais toujours solidaire de la bande métallique;
- la figure 6 est une vue partielle d'un bande métallique ayant des ouvertures délimitant les conducteurs d'un module destiné à équiper une montre électronique analogique;
- la figure 7 représente ce module pour montre avec les différents éléments qui le composent ;
- la figure 8 est une vue partielle en coupe, selon l'axe VIII-VIII, d'un des modules représentées sur la figure 4 ; et
- la figure 9 est vue partielle en coupe, selon l'axe IX-IX, du module pour montre représenté sur la figure 7.

La présente invention sera décrite en prenant comme exemple la fabrication en continu de modules électroniques complets pour cartes de crédit, chaque module étant équipé dans ce cas d'un seul composant électronique. Cette fabrication comporte une étape intermédiaire importante qui consiste à produire un ruban destiné à fournir des circuits pour les modules, cette étape constituant l'invention proprement dite. Bien entendu le ruban ainsi obtenu peut être avantageusement utilisé dans de nombreux autres domaines, en particulier pour fabriquer des modules de montres électroniques.

Pour obtenir le ruban par le procédé selon l'invention, puis les modules électroniques, il faut d'abord se munir d'une bande métallique mince. Cette bande, dont l'épaisseur est typiquement de 75 micromètres mais qui peut varier entre 50 et 150 micromètres, est avantageusement réalisée en nickel ou en ARCAP (marque déposée) (alliage de cuivre, de nickel et de zinc).

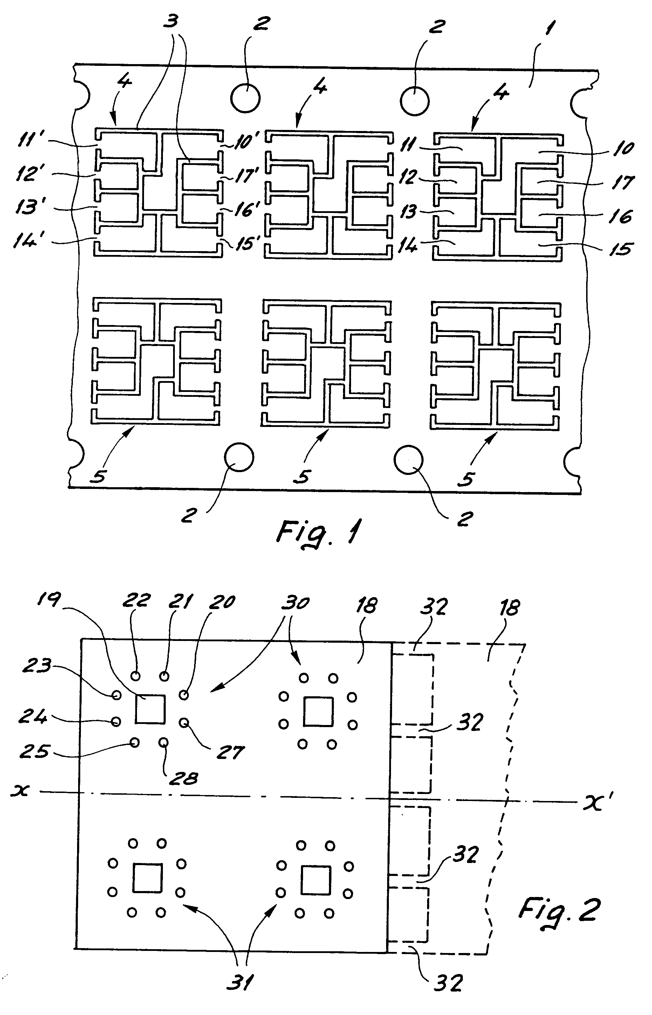

Une telle bande, référencée 1, est représentée sur la figure 1. La longueur de la bande est indéfinie alors que sa largeur est typiquement de 35 mm. Pour faciliter son déplacement dans des machines de transfert automatiques, elle peut être pourvu de perforations latérales 2.

La bande 1 comporte une série d'ouvertures référencées 3. Ces ouvertures peuvent avantageusement être obtenues par étampage, ce mode d'usinage étant propre, rapide et économique. Cependant, si la finesse ou la complexité des ouvertures ne permet pas de les étamper, il n'y a pas d'inconvénient à utiliser un procédé photolithographique car toute trace de pollution des surfaces métalliques pourra être enlevée facilement par un nettoyage à la fin de l'usinage.

Les ouvertures 3 sont réparties sur la bande de métal 1 de manière à former une suite d'ensembles identiques 4, ces ensembles étant disposés dans le sens longitudinal de la bande. La largeur de la bande représentée sur la figure 1 permet de disposer en outre une deuxième suite d'ensembles, référencée 5, parallèlement à la suite d'ensembles 4.

Chaque ensemble 4 d'ouvertures 3 délimite un réseau de conducteurs, ces conducteurs étant destinés à relier le composant électronique de chaque module à des bornes extérieures ou à des plages de contact. Dans l'exemple représenté sur la figure 1 un réseau comporte 8 conducteurs référencés de 10 à 17, chaque conducteur restant lié à la bande par un pont afin de le soutenir, ces ponts portant respectivement les références 10' à 17'. Les ponts, dans la figure 1, sont plus étroits que les conducteurs qu'ils prolongent, ceci afin de mieux les faire ressortir, mais, bien entendu, les ponts et les conducteurs pourraient avoir la même dimension transversale. Dans le cas de réseaux plus complexes, un conducteur pourrait très bien occuper une position centrale rendant impossible sa liaison directe avec le reste de la bande métallique 1. Un pont devrait alors être établi entre ce conducteur et un conducteur voisin pour lequel la liaison avec la bande est réalisable.

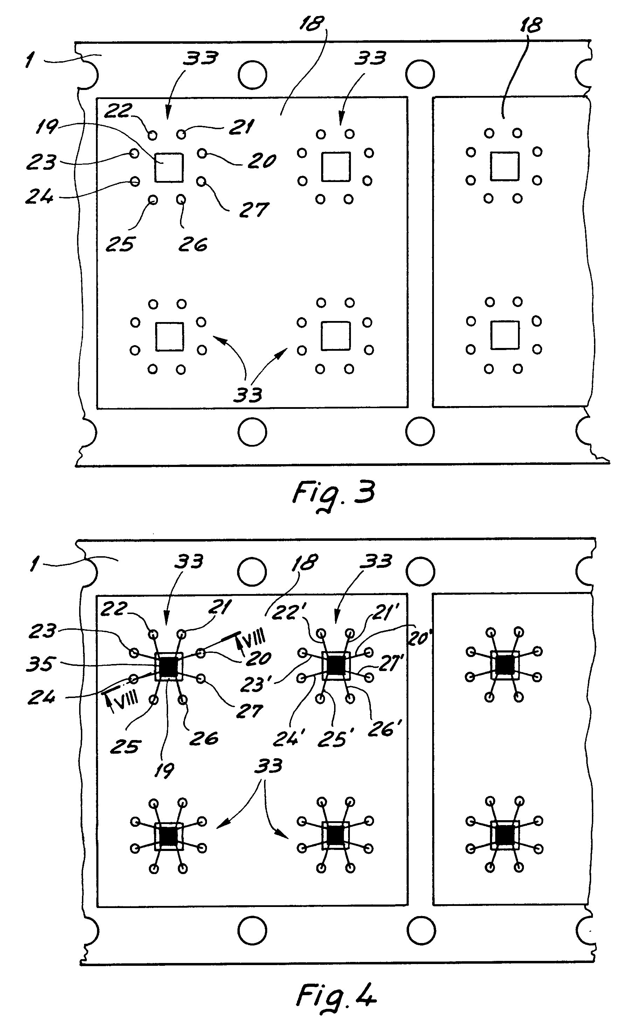

Ensuite, il faut se munir d'une feuille isolante, référencée 18 sur la figure 2, comportant une série de trous 19, 20,..27 et dont une face est recouverte par une couche de matériau adhésif. La feuille peut avantageusement être un tissu de verre ou de KAPTON (marque déposée), typiquement de 125 micromètres d'épaisseur, portant sur une face une matière thermoplastique ou une matière thermodurcissable permettant de la coller à chaud. Les matières thermoplastique et thermodurcissable peuvent être du type connu sous le nom de "Hot melt" pour la première, et du type "B-Stage epoxy" pour la deuxième. Les trous, obtenus par exemple par étampage, sont répartis sur la feuille de manière à former une suite d'ensembles idendiques 30. Dans chaque ensemble la disposition des trous correspond à la disposition des connexions devant relier les bornes du composant électronique aux conducteurs. La feuille 18 a, dans cet exemple, une forme carrée et elle ne comporte, pour des raisons qui apparaîtront par la suite, que deux ensembles 30 disposés parallèlement à un axe xx′ considéré arbitrairement comme étant l'axe longitudinal de la feuille. Deux autres ensembles, référencés 31, sont encore disposés sur la feuille parallèlement aux ensembles 30. La feuille 18, qui comporte ainsi quatre ensembles de trous, est appliquée, par sa face recouverte de la couche adhésive, sur une face de la bande métallique 1 de manière que chaque ensemble 30, 31 de trous 19,...27 vienne en regard d'un réseau de conducteurs 10,...17. A la suite de cette feuille, une autre feuille, identique à la première, est disposée sur la bande comme le montre la figure 3. Les feuilles sont ensuite collées sur la bande. Ceci est obtenu en chauffant les feuilles tout en les pressant contre cette bande. Le chauffage provoque toutefois un certain retrait du matériau isolant, ce retrait rendant difficile l'utilisation de feuilles plus grandes, surtout dans le sens longitudinal. Bien entendu avec un collage à froid le problème du retrait ne se poserait pas et des feuilles plus longues pourraient être utilisés. Par contre leur adhérence sur le métal serait moins bonne.

Les feuille isolantes 18 peuvent avantageusement être reliés les unes à la suite des autres par des ponts 32, représentés sur la figure 2, afin que ces feuilles forment une bande isolante continue, similaire à la bande métallique 1, plus facile à manipuler que des feuilles isolées. La longueur des ponts 32 est toutefois supérieure à la distance séparant deux feuilles adjacentes sur la bande métallique 1 afin de permettre le positionnement précis de chaque feuille par ses bords, par ses trous 19, 20,.. 27, ou au moyen d'autres perforations non représentées prévues à cet effet.

La bande métallique 1 et les feuilles 18 ainsi réunies forment un ruban continu, autre objet de l'invention. Ce ruban, partiellement représenté sur la figure 3 a, dans cet exemple, une épaisseur de 200 micromètres et il comporte une série de circuits identiques référencés 33, chaque circuit permettant d'obtenir un module électronique.

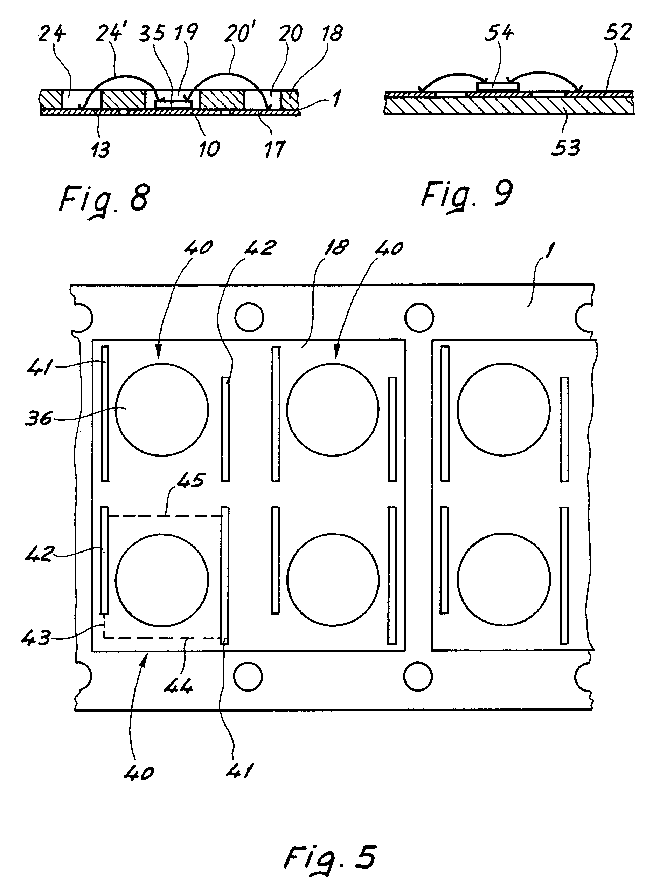

Le module pourrait être réalisé en connectant un composant électronique au circuit préalablement détaché du ruban. Il est cependant plus avantageux de garder le ruban intacte et de déposer sur la face isolante de chaque circuit 33, c'est-à-dire du côté de la feuille 18, le composant électronique, ainsi que cela est représenté en plan sur la figure 4, et en coupe selon l'axe VIII-VIII sur la figure 8. Ce composant, qui est dans cet exemple un circuit intégré référencé 35, est placé dans le trou central 19 de la feuille et fixé, par une soudure ou au moyen d'une colle, sur le conducteur 10. Les bornes du circuit intégré sont connectées, en utilisant la technique du "wire bonding", aux conducteurs 10, 11,...17 par des fils 20', 21',... 27' passant respectivement par les trous 20, 21,...27' de la feuille. Pour éviter tout dommage au module, le circuit intégré et les fils sont encore recouverts par une couche de résine opaque portant la référence 36 sur la figure 5.

Le ruban comporte à ce stade de fabrication, représenté sur la figure 5, deux rangées parallèles de modules électroniques, chaque module, référencé 40, restant relié à la bande métallique 1 par les ponts 10', 11',...17', ainsi que par la feuille 18. Les conducteurs 10, 11,..17 étant court-circuités, les modules sont protégés entre les décharges électrostatiques.

Il est encore possible de tester électriquement le module 40, sans le détacher de la bande 1, en pratiquant deux ouvertures, référencées 41 et 42 sur la figure 5, de manière à couper tous les ponts à l'exception du pont 10' qui, dans le présent cas, correspond au conducteur directement connecté à la masse du circuit intégré. Les signaux sont alors appliqués et mesurés sur les conducteurs depuis la face du circuit où ils ne sont pas recouverts par la feuille isolante 18. Bien entendu les modules ne sont alors plus protégés entre les chocs électriques.

Les tests terminés, le module 40 est séparé de la bande métallique 1 en coupant le dernier pont 10' suivant la ligne 43, et le reste de la feuille 18 suivant les lignes 44 et 45.

Le module, une fois détaché, est alors placé dans une carte de crédit de manière que la face du circuit opposée à celle qui porte le composant 35 vienne à fleur d'une face de la carte afin qu'une partie au moins des conducteurs soit accessible de l'extérieur. Cette partie des conducteurs définit alors des plages de contact pour les électrodes des appareils dans lesquels la carte est destinée à être introduite.

Le procédé de fabrication qui vient d'être décrit en prenant comme exemple un module électronique pour carte de crédit peut, bien entendu, être utilisé pour réaliser des modules destinés à d'autres applications, en particulier dans le domaine horloger.

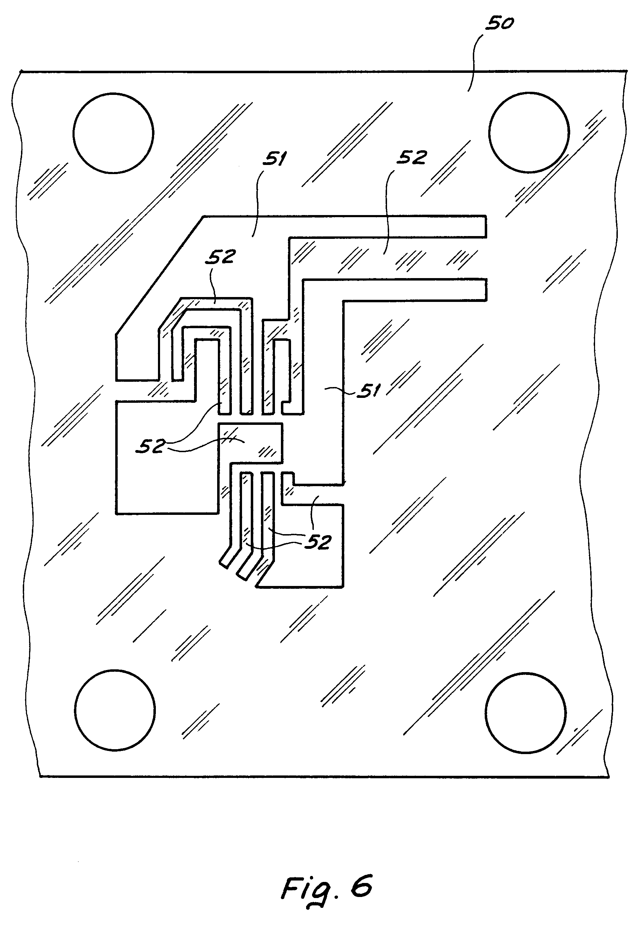

La figure 6 montre ainsi une partie d'une bande métallique 50 qui comporte un ensemble d'ouvertures 51 définissant dans cette bande un réseau de conducteurs 52 pour un module de montre électronique analogique, chaque conducteur restant lié à la bande par un pont. Les étapes intermédiaires de fabrication de tels modules ne seront pas détaillées car elles sont identiques à celles décrites à propos des modules pour cartes de crédit, et elles comprennent, en particulier, les étapes de fabrication d'un ruban destiné à fournir les circuits pour ces modules.

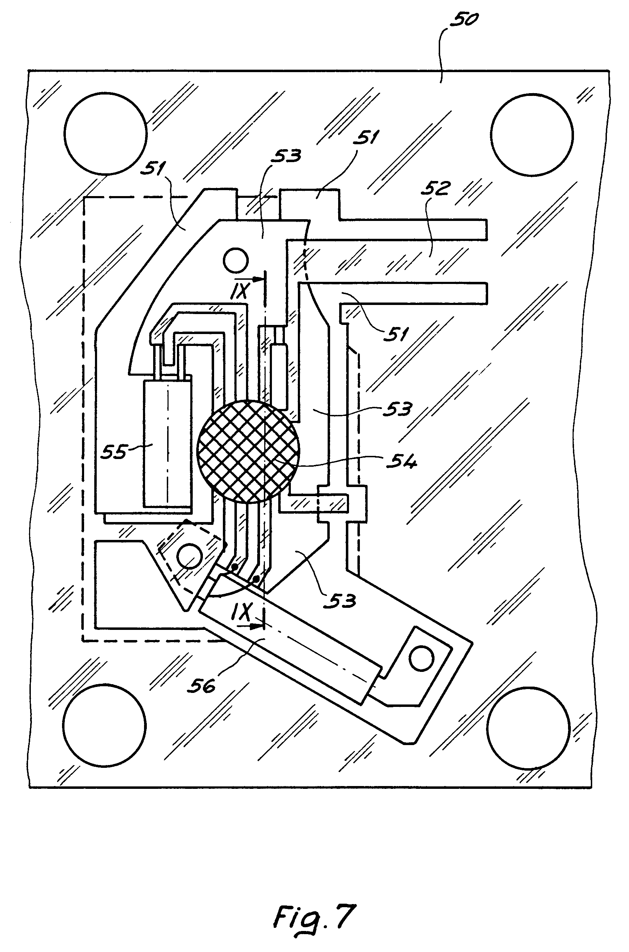

Un module de montre terminé, mais toujours relié à la bande métallique 50, est représenté en plan sur la figure 7, la face du circuit portant les conducteurs se trouvant dessus. Ce module comprend un circuit intégré 54 enrobé dans une couche de protection opaque, un résonateur à quartz 55, et une bobine 56 de moteur pas à pas. Ces composants électroniques sont disposés, contrairement au module précédent, sur la face du circuit sur laquelle se trouvent les conducteurs 52. La figure 9 montre cette disposition dans une vue en coupe faite selon l'axe IX-IX de la figure 7, le circuit étant représenté sans sa couche de protection. Il est évident que si la complexité du circuit l'exigeait, les composants pourraient être disposés sur les deux faces du circuit, la feuille 53 comportant alors des trous permettant d'établir les connexions entre les conducteurs et les composants disposés sur la face isolante du circuit.

Les connexions électriques entre le circuit intégré et les conducteurs sont obtenues, comme précédemment, à l'aide de fils fins en utilisant la même technique dite du "wire bonding". Mais d'autres techniques de connexion connues peuvent aussi être utilisées. Ainsi les bornes du résonateur à quartz et les fils de la bobine sont, dans ce module, directements soudés sur les conducteurs correspondants. Pour améliorer la fiabilité du module, à part le circuit intégré, d'autres composants peuvent encore être protégés par une couche de matière isolante.

**Revendications**

1. Procédé de fabrication en continu d'un ruban destiné à fournir une pluralité de circuits, chaque circuit étant composé d'un substrat isolant et d'un réseau de conducteurs disposés sur une face du substrat, ces conducteurs étant destinés à être connectés à au moins un composant électronique pour qu'il forme avec le circuit un module électronique, ledit procédé consistant:
   - à se munir d'une bande métallique mince et continue (1; 50) comportant une série d'ouvertures (3;51) traversant la bande de part en part, ces ouvertures délimitant les réseaux de conducteurs (10,... 17; 52) desdits circuits de manière que chaque conducteur reste lié à la bande par un pont (10',...17');
   - à se munir d'une pluralité de feuilles isolantes (18; 53), ces feuilles étant destinées à former les substrats des circuits; et
   - à coller chaque feuille (18; 53) à la suite l'une de l'autre sur une face de la bande (1; 50) au moyen d'un matériau adhésif de manière que chaque réseau de conducteurs forme, avec au moins une partie d'une feuille, un desdits circuits (33).

2. Procédé de fabrication selon la revendication 1, caractérisé en ce que les ouvertures (3; 51) de la bande métallique (1; 50) sont obtenues par étampage.

3. Procédé de fabrication selon la revendication 1 ou 2, caractérisé en ce que ledit matériau adhésif est déposé sur une face de chacune desdites feuilles (18; 53).

4. Procédé de fabrication selon l'une quelconque des revendications précédentes, caractérisé en ce que ledit matériau adhésif est une matière thermoplastique, et en ce que le collage est obtenu en pressant à chaud la feuille (18; 53) contre la bande (1;50).

5. Procédé de fabrication selon l'une quelconque des revendications 1 à 3, caractérisé en ce que ledit matériau adhésif est une matière thermodurcissable, et en ce que le collage est obtenu en pressant à chaud la feuille (18; 53) contre la bande (1; 50).

6. Procédé de fabrication selon l'une quelconque des revendications précédentes, caractérisé en ce que ladite bande (1; 50) est en nickel.

7. Procédé de fabrication selon l'une quelconque des revendications 1 à 5, caractérisé en ce que ladite bande (1;50) est en ARCAP®.

8. Procédé de fabrication selon l'une quelconque des revendications précédentes, caractérisé en ce que lesdites feuilles (18; 53) sont en tissus de verre.

9. Procédé de fabrication selon l'une quelconque des revendications 1 à 7, caractérisé en ce que lesdites feuilles (18; 53) sont en KAPTON®.

10. Procédé de fabrication selon l'une quelconque des revendications précédentes, caractérisé en ce que lesdites feuilles (18) comportent des trous (19,...27), et en ce qu'il consiste à positionner chaque feuille sur la bande (1) de manière qu'au moins certains trous se trouvent en regard d'au moins une partie des conducteurs (10,...17) afin de permettre de connecter ledit composant, disposé sur le circuit du côté de la feuille, avec ces conducteurs.

11. Ruban destiné à fournir une pluralité de circuits fabriqué selon le procédé de la revendication 1, chaque circuit étant composé d'un substrat isolant et d'un réseau de conducteurs disposés sur une face du substrat, ces conducteurs étant destinés à être connectés à au moins un composant électronique pour qu'il forme avec le circuit une module électronique, ledit ruban comprenant:

- une bande métallique mince et continue (1; 50) comportant une série d'ouvertures (3; 51) traversant la bande de part en part, ces ouvertures délimitant les réseaux de conducteurs (10,...17; 52) desdits circuits de manière que chaque conducteur reste lié à la bande par un pont (10',...17'); et
- une pluralité de feuilles isolantes (18; 53) collées sur une face de ladite bande à la suite l'une de l'autre, chaque réseau de conducteurs formant, avec au moins une partie de la feuille jouant le rôle de substrat, un desdits circuits (33).

12. Ruban selon la revendication 11, caractérisé en ce que lesdites feuilles (18) comportent des trous (19,...27) dont au moins certains se trouvent en regard d'au moins une partie des conducteurs (10,...17) afin de permettre de connecter ledit composant, disposé sur le circuit du côté de la feuille, avec ces conducteurs.

13. Ruban selon l'une des revendications 11 ou 12, caractérisé en ce que deux feuilles (18) adjacentes sont reliées entre elles par leurs bords par au moins un organe de liaison souple (32).

**Claims**

1. Method of fabricating a tape intended to provide a plurality of circuits, each circuit being made of an insulating substrate and a pattern of conductors placed on one surface of the substrate, these conductors being intended to be connected to at least one electronic component so as to form with the circuit an electronic module, said method consisting in :

- providing a thin continuous metal strip (1; 50) having a series of openings (3; 51) going right through the strip, these openings defining the patterns of conductors (10, ...17; 52) of said circuits in such a manner that each conductor remains connected to the strip by a bridge (10', ...17');
- providing a plurality of insulating sheets (18; 53), which sheets being intended to form the substrates of the circuits; and
- sticking each sheet (18; 53) one after the other onto one face of the strip by means of an adhesive in such a manner that each pattern of conductors forms, with at least one part of the sheet, one of said circuits (33).

2. Fabricating method according to claim 1, characterized in that the openings (3; 51) in the metal strip (1; 50) are produced by stamping.

3. Fabricating method according to claim 1 or 2, characterized in that said adhesive material is applied to one surface of each of said sheets (18; 53).

4. Fabricating method according to any one of the preceding claims, characterized in that said adhesive material is a thermoplastics material, and in that the sticking together is obtained by hot pressing the sheet (18; 53) against the strip (1; 50).

5. Fabricating method according to any one of claims 1 to 3, characterized in that said adhesive material is a thermosettable material, and in that the sticking together is obtained by hot pressing the sheet (18; 53) against the strip (1; 50).

6. Fabricating method according to any one of the preceding claims, characterized in that said strip (1; 50) is made of nickel.

7. Fabricating method according to any one of claims 1 to 5, characterized in that said strip (1; 50) is made of ARCAP®.

8. Fabricating method according to any one of the preceding claims, characterized in that said sheets (18; 53) are glass-fibre fabrics.

9. Fabricating method according to any one of claims 1 to 7, characterized in that said sheets (18; 53) are made of KAPTON®.

10. Fabricating method according to any one of the preceding claims, characterized in that said sheets (18) have holes (19, ...27), and in that it consists in positioning each sheet on the strip (1) in such a manner that at least some of the holes are located facing at least one part of the conductors (10, ...17) in order to enable said component, placed on the circuit on the same side as the sheet, to be connected to these conductors.

11. Tape intended to provide a plurality of circuits produced according to the method of claim 1, each circuit being composed of an insulating substrate and a pattern of conductors placed on one surface of the substrate, these conductors being intended to be connected to at least one electronic component to form with the circuit an electronic module, said tape comprising :

- a thin and continuous metal strip (1; 50) having a series of openings (3; 51) passing right through the strip, these openings defining the patterns of conductors (10, ...17; 52) of said circuits in such a manner that each conductor remains connected to the strip by a bridge (10', ...17'); and

- a plurality of insulating sheets (18; 53) stuck onto one surface of said strip one after the other, each pattern of conductors forming, with at least one substrate-forming part of the sheet, one of said circuits (33).

12. Tape according to claim 11, characterized in that said sheets (18) include holes (19, ...27) at least some of which are located facing at least one part of the conductors (10, ...17) in order to enable said component, placed on the circuit on the same side as the sheet, to be connected to these conductors.

13. Tape according to claim 11 or 12, characterized in that two adjacent sheets (18) are connected together by their edges by at least one flexible connection member (32).

**Patentansprüche**

1. Verfahren zur kontinuierlichen Herstellung eines Bandes, das eine Mehrzahl von Schaltungen ergeben soll, wobei jede Schaltung aus einem isolierenden Substrat und einem Netz von Leitungen, die auf einer Seite des Substrats angeordnet sind, besteht und diese Leitungen dazu bestimmt sind, an zumindest einen elektronischen Bauteil angeschlossen zu werden, damit dieser mit der Schaltung einen elektronischen Modul bildet, wobei das Verfahren darin besteht,

- daß man einen dünnen und kontinuierlichen Metallstreifen nimmt (1; 50), der eine Reihe von Öffnungen (3; 51) besitzt, welche den Streifen zur Gänze durchsetzen, wobei diese Öffnungen die Leitungsnetze (10,...17; 52) der Schaltungen so begrenzen, daß jede Leitung mit dem Streifen durch eine Brücke (10',...17') verbunden bleibt;

- daß man eine Mehrzahl von isolierenden Folien (18; 53) nimmt, die dazu bestimmt sind, die Substrate der Schaltungen zu bilden; und

- daß man jede Folie (18; 53), eine nach der anderen, mit einem Klebstoff auf eine Seite des Streifens (1; 50) aufklebt, so daß jedes Leitungsnetz mit zumindest einem Teil einer Folie eine der erwähnten Schaltungen (33) bildet.

2. Herstellungsverfahren nach Anspruch 1, dadurch gekennzeichnet, daß die Öffnungen (3; 51) des Metallstreifens (1; 50) durch Stanzen erzielt werden.

3. Herstellungsverfahren nach Anspruch 1 oder 2, dadurch gekennzeichnet, daß der Klebstoff auf einer Seite der Folien (18; 53) abgelegt wird.

4. Herstellungsverfahren nach einem der vorstehenden Ansprüche, dadurch gekennzeichnet, daß der Klebstoff ein thermoplastisches Material ist und daß die Verklebung durch Heißverpressen der Folie (18; 53) mit dem Band (1; 50) erfolgt.

5. Herstellungsverfahren nach einem der Ansprüche 1 bis 3, dadurch gekennzeichnet, daß der Klebstoff ein wärmeaushärtendes Material ist, und daß die Verklebung durch Heißverpressen der Folie (18; 53) mit dem Band (1; 50) erfolgt.

6. Herstellungsverfahren nach einem der vorstehenden Ansprüche, dadurch gekennzeichnet, daß das Band (1; 50) aus Nickel besteht.

7. Herstellungsverfahren nach einem der Ansprüche 1 bis 5, dadurch gekennzeichnet, daß das Band (1; 50) aus ARCAP® besteht.

8. Herstellungsverfahren nach einem der vorstehenden Ansprüche, dadurch gekennzeichnet, daß die Folien (18; 53) aus Glasgewebe bestehen.

9. Herstellungsverfahren nach einem der Ansprüche 1 bis 7, dadurch gekennzeichnet, daß die Folien (18; 53) aus KAPTON® bestehen.

10. Herstellungsverfahren nach einem der vorstehenden Ansprüche, dadurch gekennzeichnet, daß die Folien (18) Löcher (19,...27) besitzen und daß es darin besteht, jede Folie so auf dem Band (1) zu positionieren, daß sich wenigstens einige Löcher über zumindest einem Teil der Leitungen (10,...17) befinden, damit der auf der Seite der Folie auf der Schaltung angeordnete Bauteil an diese Leitungen angeschlossen werden kann.

11. Band, das eine Mehrzahl von Schaltungen ergeben soll, das nach dem Verfahren von Anspruch 1 hergestellt wurde, wobei jede Schaltung aus einem isolierenden Substrat und einem Netz von auf einer Seite des Substrats angeordneten Leitungen besteht, wobei diese Leitungen dazu bestimmt sind, an zumindest einen elektronischen Bauteil angeschlossen zu werden, damit er mit der Schaltung einen elektronischen Modul bildet, wobei dieses Band
   - aus einem dünnen und kontinuierlichen Metallstreifen (1; 50) mit einer Reihe von Öffnungen (3; 51), welche das Band vollständig durchsetzen und diese Öffnungen die Leitungsnetze (10,...17; 52) der Schaltungen so begrenzen, daß jede Leitung mit dem Band durch eine Brücke (10',...17') verbunden bleibt; und
   - aus einer Mehrzahl von isolierenden Folien (18; 53), die auf eine Seite des Bandes eine nach der anderen aufgeklebt sind, wobei jedes Leitungsnetz zumindest mit einem Teil der als Substrat dienenden Folie eine der erwähnten Schaltungen (33) bildet, besteht.

12. Band nach Anspruch 11, dadurch gekennzeichent, daß die Folien (18) Löcher (19,...27) besitzen, von denen sich wenigstens einige über zumindest einem Teil der Leitungen (10,...17) befinden, damit der auf der Schaltung auf der Seite der Folie angeordnete Bauteil an diese Leitungen angeschlossen werden kann.

13. Band nach einem der Ansprüche 11 oder 12, dadurch gekennzeichnet, daß die beiden nebeneinander liegenden Folien (18) an ihren Rändern durch zumindest ein flexibles Verbindungsmittel (32) miteinander verbunden sind.

Fig. 1

Fig. 2

Fig. 3

Fig. 4

24  24'  35  19  20'  20  18

54  52

13  10  17

53

Fig. 8

Fig. 9

40  42  18  40  1

41

36

45

42

43

44

40  41

Fig. 5

EP 0 296 511 B1

Fig. 6

Fig.7